# EUROPEAN PATENT SPECIFICATION

(11) **EP 2 413 673 B1**
(45) Date of publication and mention of the grant of the patent: **31.08.2016**
(21) Application number: 11175657.3
(22) Date of filing: 27.07.2011
(51) Int. Cl.: H05K 1/02, H01B 7/08, H01B 11/04

(54) **Wiring system**
Verdrahtungssystem
Système de câblage

(30) Priority: 28.07.2010 GB 201012688
(43) Date of publication of application: 01.02.2012
(73) Proprietor: In2Tec Limited, Garrard Way Kettering Northamptonshire NN16 8TD (GB)
(72) Inventor: Lewison, John, Kettering, Northamptonshire NN16 8TD (GB)
(74) Representative: South, Nicholas Geoffrey

(56) References cited:
- JP-A- H05 120 928
- JP-A- 2002 118 333
- US-A- 3 764 727
- US-A- 5 430 247
- US-A1- 2003 222 727
- US-A1- 2004 094 328
- US-A1- 2004 221 647
- US-A1- 2007 151 748
- US-A1- 2010 163 282
- US-B1- 6 420 659

## Description

The present invention relates to a wiring system, and in particular a wiring system having at least one pair of conductors deposited on a flexible substrate.

In electric circuits, it is well known to use twisted pair cabling, in which two conductors are twisted together in order to reduce the effect of electromagnetic interference from external sources, as well as cross talk between adjacent pairs of cables. The ability to produce a compact arrangement of multiple twisted pair cables is limited by the minimum distance between pairs of cables to avoid cross talk. The electrical characteristics of the cabling are also limited by the thickness of the cable insulation between the twisted conductors themselves, which restricts how close the conductors can be placed to one another.

It is also known to produce arrangements of 'pseudo-twisted' pairs of conductors, in which conductors are applied to opposite sides of a substrate, in patterns arranged such that their paths repeatedly cross over when viewed from above, thereby simulating the effect of actual twisted pair wiring and reducing cross talk and interference. EP 0809260 A2 discloses an example of such an arrangement, in the form of a flat flexible electrical cable, comprising a plurality of adjacent pairs of pseudo-twisted conductors. However, this arrangement is restricted to producing a single layer of conductors on each side of the substrate. Furthermore, the arrangement still only performs the function of a conventional ribbon cable, and it would be desirable to produce a wiring arrangement which could be adapted to specific applications, both in terms of functionality and physical requirements.

US 2003/222727 A1 discloses a non-uniform transmission line including at least one patterned conductive layer, a dielectric layer adjacent to the patterned conductive layer(s), and an insulating layer surrounding the patterned conductive layer(s) and the dielectric layer.

US 2007/151748 A1 discloses a flexible carrier having a plastic base layer and at least one electrically conducting layer arranged between the base layer and at least one plastic covering layer.

US 3764727 A discloses a flat cable structure including a number of pairs of longitudinally extending conductors in a substantially flat array. The conductors of each pair are spaced laterally from one another except at periodic locations where the conductors of the pair exchange lateral positions by crossing over one another.

US 2010/163282 A1 discloses a flexible printed wiring board comprising first and second wave-shape wirings provided between at least two insulation substrates stacked on each other, to form a twisted pair pattern.

US 5061830 A discloses an electrical switch system, which is comprised of relatively long conductors disposed on a flexible resilient film.

US 2004/221647 A1 discloses a flexible liquid level sensor board assembly.

US 2004/094328 A1 discloses an assembly for conducting an electronic signal, including a substrate and an electronic cable extending through first and second through-holes provided in the substrate.

US 6420659 A discloses a flexible wiring board having circuit wiring patterns coated with insulating films.

Further pertinent prior art is described in JP 5 120928 A and JP 2002 118333 A. The present invention provides a wiring system as claimed in claim 1. The invention also provides a flexible wiring harness including a wiring system having plurality of conductor pairs.

The conductors may be formed in layers on the substrate so that the paths lie in separate planes, with appropriate insulating material separating the conductors. Alternatively, the deposited conductors are interweaved to produce a pair of conductors on the substrate which is actually in a twisted configuration. Such interweaving may be achieved by depositing partial conductor paths on the substrate, followed by a deposited insulating layer, and then depositing a second set of partial conductors arranged to complete the two continuous paths of the paired conductors. In this way, the paths of the conductors can be arranged to interweave, or twist, in relation to one another.

The conductors typically comprise silver based inks/adhesives which after deposition can be cured to provide conductive paths with either flexible or rigid characteristics. Other materials may be used, including for example carbon, other metals or various suitable conductive compounds.

The thickness of the conductor may be of the order of tens of microns, thereby allowing a very compact arrangement together with excellent electrical characteristics. In particular, the conductors are preferably sufficiently thin to provide a compact and flexible arrangement, and the deposited conductors may have a thickness less than 100 µm, preferably less than 50 µm, and more preferably less than 20 µm. Furthermore, it has been found that the electrical characteristics of the conductor pairs improve, the closer the conductors are located to one another at the points where the individual conductor paths cross over. Using the present invention, it has been found possible to obtain excellent electrical characteristics by achieving a thin film separation of the deposited tracks of around 20 µm at the cross over points, and in any case typically less than 100 µm.

The conductors can be applied to a thin flexible supporting substrate, or tape, which enables the conductors to be formed and selectively applied or adhered to any support structure, such as a contoured surface. For example, when the invention is used for the wiring in a car, it is possible to apply a flexible wiring system to the chassis so that the flexible substrate is contoured and formed in both a 2 dimensional or 3 dimension structure in the shape of the surface to which it is applied, instead of having to feed a wiring loom or cable harness through holes provided in the chassis or container in which it is installed.

Optionally, full or localised EMC or ESD electrical shielding can be achieved by applying a protective conductive layer over the insulated deposited conductors. In this way, the shielding layer can be formed as an integral part of the structure which may extend over its entirety, and may be applied to any given conductor, or group of conductors, as required. Selective shielding can provide protection in areas where environment exposure risks are increased. Shielding can be incorporated within the layer structure to isolate pairs or groups of pairs from each other.

Arrangements of printed conductors can be grouped side by side and/or stacked in layers, optionally with individual full electrical shielding, in order to provide a composite wiring harness of any suitable size. The individual conductors and pairs of conductors may also be formed in any suitable size, according to the application and the respective electrical circuit. In this way, multiple pairs of conductors can be arranged to form a flexible tape structure. For example, pairs of conductors can be arranged side by side to form a flat ribbon strip, equivalent to a conventional ribbon cable, or may instead be arranged with one pair above another. It will be appreciated that multiple pairs of conductors may be arranged in any combination of side by side and stacked orientations.

A wiring system according to the invention may be provided with localised areas of mechanical protection along part or all of its length, which may include areas where the overall construction is stiffened or includes other overlayed materials, while other areas may remain flexible. The differing properties of different areas of the wiring system will be determined by the application that the system is designed for.

As well as providing conductors having a twisted pair-like arrangement to reduce cross talk, it is also possible to form or attach electrical/electronic components integrally on the substrate and circuit in the same manner. Such components may include for example resistors or small capacitors, and may be printed or otherwise deposited as discrete items on the substrate, or may be secured to the substrate by conductive bonding or other suitable means. Similarly, switching components may also be printed or otherwise incorporated on the substrate at any point along the length of the wiring system. Such integrated switching components allow particular conductors, or circuit branches, to be activated or isolated from the circuit in response to switching inputs or other changes in surrounding conditions. For example, the user may not require all conductor pairs to be active continuously and may only require a pair to be active in response to external stimulus, e.g. the initiation of a diagnostic mode. In the invention, such components are used to indicate the status of particular conductors or circuit branches, for example by providing integrated LED indicators within the wiring bundle. In other arrangements, the attachment of sensor inputs, or other opto-coupling devices, can allow isolated inputs to the system.

In addition, the pattern of any one of the printed conductors may be arranged to allow access to the conductor at any point along its length. Such access may be desired for testing purposes after the wiring arrangement has been completed, or for readings to be taken from individual conductors, etc. The patterns of the individual conductors within a wiring system may also be arranged so that individual conductors can enter or leave the harness at any point along its length, and individual conductors may branch to and from one or more entry or exit points. Multiple entry/exit points may be included for connection to one or more pairs of conductors.

In order that the invention may be well understood, embodiments thereof will now be described, by way of example, reference being made to the accompanying drawings, in which:
Figures 1(a)-(d) are schematic plan views of different arrangements of conductor pairs mounted on flexible substrates;
Figure 2(a) is a schematic perspective view of a conductor pair mounted on a substrate;
Figure 2(b) is a schematic end view of the arrangement of Figure 2(a); Figure 2(c) is a cross-sectional view along the line A-A in Figure 2(a); Figure 2(d) is a cross-sectional view along the line B-B in Figure 2(a); and Figure 2(e) is a cross-sectional view along the line A-A in Figure 2(a) in an alternative arrangement;
Figure 3 is a schematic perspective view of an alternative arrangement of a conductor pair mounted on a substrate;
Figure 4 is a schematic cross-sectional view of a conductor pair with electrical shielding;
Figure 5 shows a flexible wiring system affixed to the chassis of a vehicle; and
Figure 6 is a schematic plan view of a conductor pair mounted on a substrate, provided with take off points.

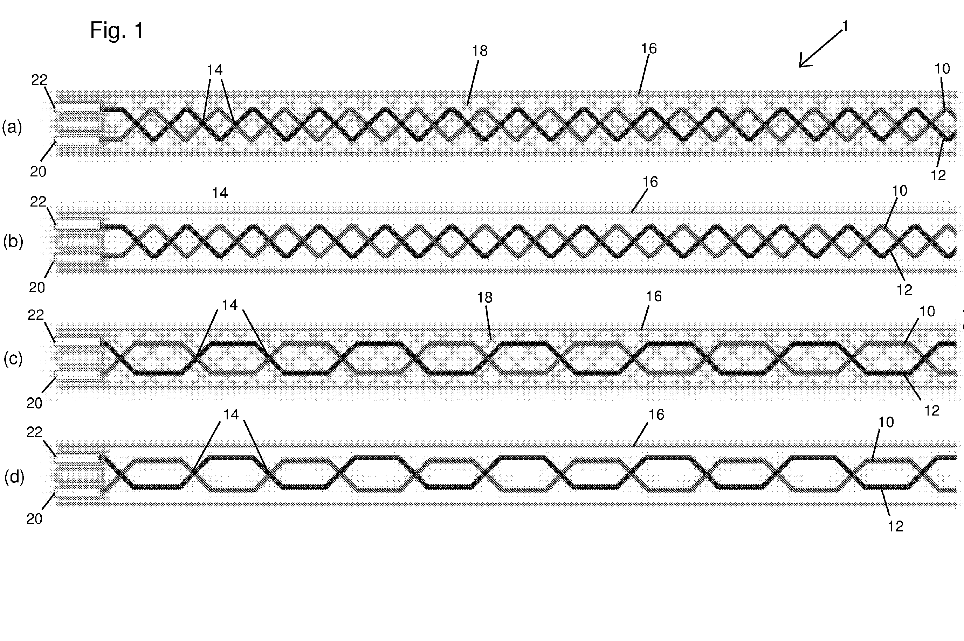

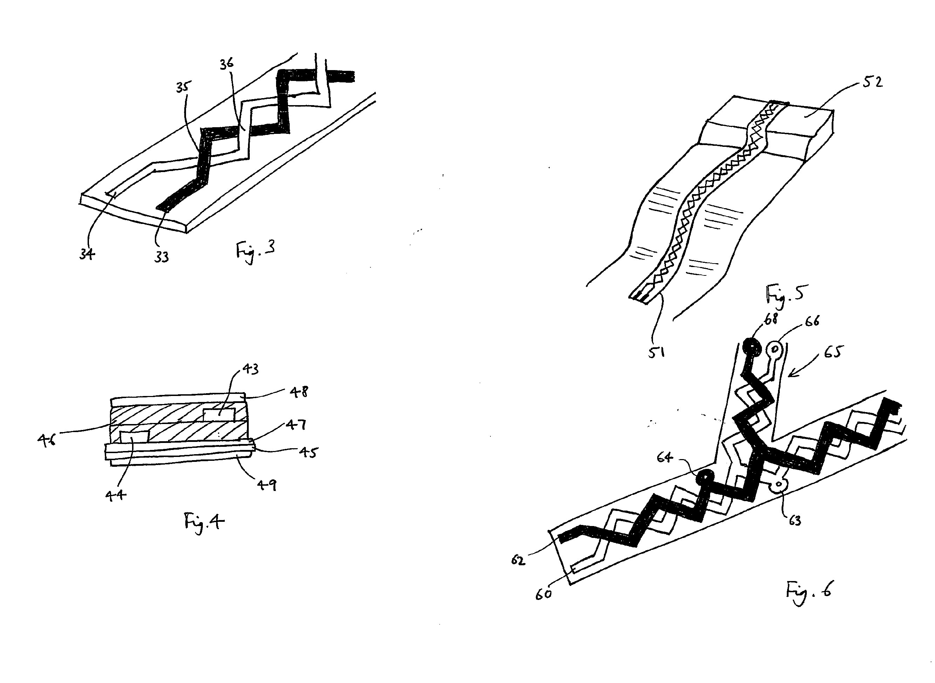

In each configuration shown in Figures 1(a)-(d), a wiring system (1) is shown comprising a pair of conductors (10, 12), wherein the conductors are arranged in a pattern such that the paths of the conductors repeatedly cross over at multiple crossover points (14), to achieve the same effect as conventional twisted pair arrangements. The individual conductors may be arranged on separate layers of material, one above the other on top of the substrate (16) with appropriate insulation in between, or may be deposited on the substrate in such a way that they are actually interweaved to twist over one another at the crossover points. The illustrated conductors are provided with respective connectors (20, 22) at the end of the substrate. In some arrangements, a solid or meshed conductor is provided on a separate layer either on top of or between the twisted conductors, to provide electromagnetic shielding. Figures 1(a) and 1(c) show such a meshed conductor (18). Any or each pair may have one or more exit take off points allowing data to be received or provided from a conductor pair to or from multiple locations. Such take off points are shown in the arrangement of Figure 6, in which the conductors (60, 62) are provided with terminals (63, 64) at a point along the substrate, and also illustrates the provision of a side branch (65) which terminates in additional terminals (66, 68) which can be more easily accessed.

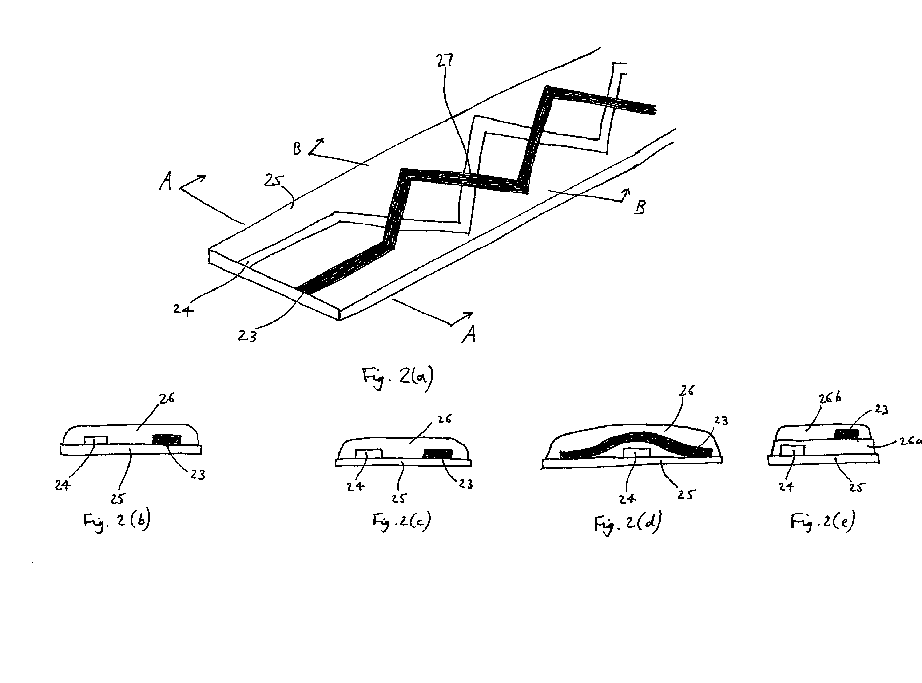

Figure 2(a) shows schematically a pair of conductors (23, 24) mounted on a substrate (25) in a wiring system according to the invention. As also shown in Figures 1(a)-(d), the conductors are arranged in patterns such that their paths cross at multiple crossover points (27). In this case, the first conductor (23) is arranged to always overlie the second conductor (24) at the crossover points. To illustrate the construction in more detail, Figure 2(b) shows schematically an end view of the arrangement, showing the conductors (23, 24) side by side on the substrate (25), and covered by a layer of insulating material (26) which encapsulates and insulates the top and sides of the conductors. Figure 2(c) shows a cross-sectional view along the line A-A of Figure 2(a), illustrating substantially the same arrangement of components at that point as in Figure 2(b). Figure 2(d) shows a cross-sectional view along the line B-B of Figure 2(a), illustrating that the conductors are generally arranged in the same plane, but that at the crossover point (27) in Figure 2(a), the first conductor (23) is formed so as to lie over the second conductor (24), with the two conductors being separated by a portion of the insulating material (26). As described previously, it is advantageous for the separation between the conductors at the crossover points to be small.

Figure 2(e) shows a cross-sectional view along the line A-A in Figure 2(a) in an alternative arrangement not forming part of the invention, in which the conductors are arranged in separate layers on the substrate. In this arrangement, one conductor (24) is formed on the substrate (25) and covered by a first insulating layer (26a). The other conductor (23) is then formed on top of the first insulating layer (26a), and covered by a second insulating layer (26b).

Figure 3 shows an arrangement in accordance with the invention, in which the conductors (33, 34) are formed in paths which are interweaved, or twisted, so that the first conductor (33) overlies the second conductor (34) at a first crossover point (35), but the second conductor (34) overlies the first conductor (33) at a subsequent crossover point (36). This arrangement more closely resembles a conventional twisted pair arrangement, in the sense that the conductors are in effect twisted around one another, rather than merely being formed on separate layers in overlying paths which repeatedly cross one another when viewed from above.

Figure 4 shows a cross-sectional view of an arrangement similar to that of Figure 2(e), but which is provided with shielding layers. The conductors (43, 44) are formed in layers of insulating material (46) and are, in this arrangement, located between first and second shielding layers (47, 48), although it will be appreciated that one or more shielding layers may be provided in various configurations, as appropriate. The first shielding layer (47) is positioned adjacent to the flexible substrate (45), such that the entire arrangement of shielding layers, conductors and insulating material is formed on one side of the substrate. In the illustrated arrangement, a fixative layer (49) is provided on the other side of the substrate, in order that the flexible wiring assembly may be attached to a contoured surface.

It will be appreciated that many variations of the conductors and shielding layers are possible. Multiple pairs of the conductors shown in Figure 1 can be arranged side by side or stacked on top of one another, in any combination, as required in a particular application, having regard to available space and the required flexibility of the complete wiring system. The individual conductor pairs can be mounted on separate substrates which are then combined to form the complete system, or multiple conductor pairs can be deposited on the same substrate, as required.

It will be appreciated that due to the nature of the thin printed conductors and flexible substrate, wiring arrangements in accordance with the invention can be used in a large number of applications where it is desirable to provide a plurality of conductor pairs in a compact arrangement, with reduced cross talk and susceptibility to electromagnetic interference from external sources. In particular, the invention is advantageous in applications where the wiring harness is required to be flexible and/or to be applied to a contoured surface, or otherwise applied in a small space. Such applications include, but are not limited to, use in wiring throughout a vehicle chassis, and use in audio applications. As an example, Figure 5 illustrates a wiring system (51) in accordance with the invention, formed and affixed to a contoured vehicle chassis (52).

## Claims

1. A wiring system (1) comprising a flexible substrate (16; 25) and at least one pair of conductors (10, 12; 23, 24; 33, 34) disposed on the substrate, wherein the conductors are each arranged in a pattern defining a respective conductive path, and the paths of the pair of conductors are arranged to cross one another at a plurality of crossover points (14; 27; 35, 36), and wherein the conductors of the or each pair are arranged on the same side of the substrate, wherein the conductors (10, 12; 23, 24; 33, 34) of the or each pair are generally arranged on the substrate (16; 25) in the same plane as one another, except at the crossover points, and each conductor comprises a conductive track formed by printing on the substrate, **characterised in that** at least one conductor pair is branched to form a plurality of circuit branches, and the system further comprises a plurality of electrical or electronic components formed on respective circuit branches for indicating a status of one or more of the conductors.

2. The wiring system of claim 1, wherein the planes of the conductors of a conductor pair are separated from one another at the crossover points by an insulating material.

3. The wiring system of claim 1 or 2, wherein the conductors of a conductor pair (33, 34) are formed on the substrate in paths which are interweaved so that a first conductor (33) of the pair overlies the second conductor (34) of the pair at a first crossover point (35), and the second conductor (34) overlies the first conductor (33) at a subsequent crossover point (36).

4. The wiring system of any preceding claim, wherein the thickness of at least one of the conductors is less than 100 µm.

5. The wiring system of any preceding claim, wherein the distance between the conductors of a conductor pair at the crossover points is less than 40 µm.

6. The wiring system of any preceding claim, comprising a plurality of conductor pairs arranged to provide a flexible wiring harness.

7. The wiring system of claim 6, comprising a plurality of conductor pairs arranged side by side on the substrate, and/or a plurality of conductor pairs arranged in a stacked formation.

8. The wiring system of any preceding claim, comprising at least one shielding layer (47, 48) formed over a conductor or group of conductors (43, 44), whereby to provide electromagnetic shielding of said conductor(s).

9. The wiring system of any preceding claim, comprising stiffening means along at least part of the length of the substrate.

10. The wiring system of claim 9, wherein the system is arranged to remain flexible along at least part of the length of the substrate.

11. The wiring system of any preceding claim, further comprising at least one electrical switching component formed on the substrate, whereby to allow conductors or combinations of conductors to be activated or isolated from a circuit of which they form a part.

12. The wiring system of claim 11, wherein the switching components are formed by printing on the substrate.

13. The wiring system of claim 11 or 12, further comprising at least one electrical component formed on the substrate and arranged to indicate the status of one or more conductors with reference to connection to a circuit.

14. A wiring harness comprising a wiring system as claimed in claim 6, wherein the wiring system is arranged such that at least one circuit branch is a side branch (65) to allow external access to at least one conductor, at at least one point (63, 64, 66, 68) between ends of the wiring harness along its length, for electrical measurement or testing purposes.

15. The wiring harness of claim 14, wherein the harness is arranged to be sufficiently flexible to allow application to a three-dimensional contoured non-planar surface (52), and/or the harness is formed to the shape of a three-dimensional contoured non-planar surface for application to that surface.

## Patentansprüche

1. Verdrahtungssystem (1), das ein flexibles Substrat (16; 25) und mindestens ein Paar von Leitern (10, 12; 23, 24; 33, 34), die auf dem Substrat angeordnet sind, umfasst, wobei die Leiter jeweils in einem Muster angeordnet sind, das eine entsprechende Leiterbahn definiert, und die Bahnen des Paars von Leitern so angeordnet sind, dass sie einander an einer Vielzahl von Kreuzungspunkten (14; 27; 35, 36) kreuzen, und wobei die Leiter des oder jedes Paares auf der gleichen Seite des Substrats angeordnet sind,
wobei die Leiter (10, 12; 23, 24; 33, 34) des oder jedes Paares im Allgemeinen auf dem Substrat (16; 25) in der gleichen Ebene zueinander angeordnet sind, ausgenommen an den Kreuzungspunkten, und jeder Leiter eine Leiterspur umfasst, die durch Drucken auf dem Substrat gebildet ist,
**dadurch gekennzeichnet, dass** zumindest ein Leiterpaar verzweigt ist, um eine Vielzahl von Schaltungszweigen zu bilden, und
das System ferner eine Vielzahl von elektrischen oder elektronischen Komponenten umfasst, die auf entsprechenden Schaltungszweigen gebildet sind, um einen Status von einem oder mehreren der Leiter anzuzeigen.

2. Verdrahtungssystem nach Anspruch 1, wobei die Ebenen der Leiter eines Leiterpaares an den Kreuzungspunkten durch ein isolierendes Material voneinander getrennt sind.

3. Verdrahtungssystem nach Anspruch 1 oder 2, wobei die Leiter eines Leiterpaares (33, 34) auf dem Substrat in Pfaden gebildet sind, die verflochten sind, so dass ein erster Leiter (33) des Paares über dem zweiten Leiter (34) des Paares an einem ersten Kreuzungspunkt (35) liegt und der zweite Leiter (34) über dem ersten Leiter (33) an einem nachfolgenden Kreuzungspunkt (36) liegt.

4. Verdrahtungssystem nach einem der vorhergehenden Ansprüche, wobei die Dicke von mindestens einem der Leiter weniger als 100 µm beträgt.

5. Verdrahtungssystem nach einem der vorhergehenden Ansprüche, wobei der Abstand zwischen den Leitern eines Leiterpaares an den Kreuzungspunkten weniger als 40 µm beträgt.

6. Verdrahtungssystem nach einem der vorhergehenden Ansprüche, das eine Vielzahl von Leiterpaaren umfasst, die so angeordnet sind, dass sie einen flexiblen Kabelbaum bereitstellen.

7. Verdrahtungssystem nach Anspruch 6, das Folgendes umfasst: eine Vielzahl von Leiterpaaren, die nebeneinander auf dem Substrat angeordnet sind, und/oder eine Vielzahl von Leiterpaaren, die in einer gestapelten Formation angeordnet sind.

8. Verdrahtungssystem nach einem der vorhergehenden Ansprüche, das mindestens eine Abschirmungsschicht (47, 48) umfasst, die über einem Leiter oder einer Gruppe von Leitern (43, 44) gebildet ist, wodurch eine elektromagnetische Abschirmung des Leiters bzw. der Leiter bereitgestellt wird.

9. Verdrahtungssystem nach einem der vorhergehenden Ansprüche, das ein Versteifungsmittel entlang mindestens eines Teils der Länge des Substrats umfasst.

10. Verdrahtungssystem nach Anspruch 9, wobei das System so angeordnet ist, dass es entlang mindestens eines Teils der Länge des Substrats flexibel bleibt.

11. Verdrahtungssystem nach einem der vorhergehenden Ansprüche, das ferner mindestens eine elektrische Schaltkomponente umfasst, die auf dem Substrat gebildet ist, wodurch Leiter oder Kombinationen von Leitern aktiviert oder von einer Schaltung, von der sie einen Teil bilden, getrennt werden können.

12. Verdrahtungssystem nach Anspruch 11, wobei die Schaltkomponenten durch Drucken auf dem Substrat gebildet werden.

13. Verdrahtungssystem nach Anspruch 11 oder 12, das ferner mindestens eine elektrische Komponente umfasst, die auf dem Substrat gebildet ist und so angeordnet ist, dass sie den Status von einem oder mehreren Leitern unter Bezugnahme auf eine Verbindung mit einer Schaltung anzeigt.

14. Kabelbaum, der ein Verdrahtungssystem nach Anspruch 6 umfasst, wobei das Verdrahtungssystem so angeordnet ist, dass mindestens ein Schaltungszweig ein Seitenzweig (65) ist, um einen externen Zugriff auf mindestens einen Leiter an zumindest einem Punkt (63, 64, 66, 68) zwischen den Enden des Kabelbaums entlang seiner Länge für elektrische Mess- oder Testzwecke zu ermöglichen.

15. Kabelbaum nach Anspruch 14, wobei der Kabelbaum so angeordnet ist, dass er flexibel genug ist, um auf einer dreidimensionalen konturierten nicht-planaren Oberfläche (52) angebracht zu werden, und/oder wobei der Kabelbaum gemäß der Form einer dreidimensionalen konturierten nicht-planaren Oberfläche zur Anbringung an diese Oberfläche geformt ist.

## Revendications

1. Système de câblage (1) comprenant un substrat souple (16 ; 25) et au moins une paire de conducteurs (10, 12 ; 23, 24 ; 33, 34) disposée sur le substrat, dans lequel les conducteurs sont agencés chacun dans une configuration définissant un chemin conducteur respectif, et les chemins de la paire de conducteurs sont agencés pour se croiser à une pluralité de points de croisement (14 ; 27 ; 35, 36), et dans lequel les conducteurs de la ou de chaque paire sont agencés sur le même côté du substrat,
dans lequel les conducteurs (10, 12 ; 23, 24 ; 33, 34) de la ou de chaque paire sont généralement agencés sur le substrat (16 ; 25) dans le même plan les uns les autres, sauf aux points de croisement, et chaque conducteur comprend une piste conductrice formée par impression sur le substrat,
**caractérisé en ce que**
au moins une paire de conducteurs est ramifiée pour former une pluralité de branches de circuit, et
le système comprend en outre une pluralité de composants électriques ou électroniques formés sur des branches de circuits respectives pour indiquer un état d'un ou de plusieurs des conducteurs.

2. Système de câblage selon la revendication 1, dans lequel les plans des conducteurs d'une paire de conducteurs sont séparés l'un de l'autre aux points de croisement par un matériau isolant.

3. Système de câblage selon la revendication 1 ou 2, dans lequel les conducteurs d'une paire de conducteurs (33, 34) sont formés sur le substrat dans des chemins qui sont entrelacés de telle sorte qu'un premier conducteur (33) de la paire recouvre le second conducteur (34) de la paire à un premier point de croisement (35), et le second conducteur (34) recouvre le premier conducteur (33) à un point de croisement suivant (36).

4. Système de câblage selon l'une quelconque des revendications précédentes, dans lequel l'épaisseur d'au moins l'un des conducteurs est inférieure à 100 µm.

5. Système de câblage selon l'une quelconque des revendications précédentes, dans lequel l'épaisseur entre les conducteurs d'une paire de conducteurs aux points de croisement est inférieure à 40 µm.

6. Système de câblage selon l'une quelconque des revendications précédentes, comprenant une pluralité de paires de conducteurs agencée pour fournir un faisceau de câblage souple.

7. Système de câblage selon la revendication 6, comprenant une pluralité de paires de conducteurs agencées côte à côte sur le substrat, et/ou une pluralité de paires de conducteurs agencée dans une formation empilée.

8. Système de câblage selon l'une quelconque des revendications précédentes, comprenant au moins une couche de blindage (47, 48) formée par-dessus un conducteur ou groupe de conducteurs (43, 44), de façon à blinder électromagnétiquement ledit ou lesdits conducteurs.

9. Système de câblage selon l'une quelconque des revendications précédentes, comprenant un moyen de raidissement le long d'au moins une partie de la longueur du substrat.

10. Système de câblage selon la revendication 9, le système étant agencé pour rester souple le long d'au moins une partie de la longueur du substrat.

11. Système de câblage selon l'une quelconque des revendications précédentes, comprenant en outre au moins un composant de commutation électrique formé sur le substrat, de manière à permettre l'activation de conducteurs ou de combinaisons de conducteurs ou leur isolement d'un circuit dont ils font partie.

12. Système de câblage selon la revendication 11, dans lequel les composants de commutation sont formés par impression sur le substrat.

13. Système de câblage selon la revendication 11 ou 12, comprenant en outre au moins un composant électrique formé sur le substrat et agencé pour indiquer l'état d'un ou de plusieurs conducteurs relativement à leur connexion à un circuit.

14. Faisceau de câblage comprenant un système de câblage selon la revendication 6, dans lequel le système de câblage est agencé de telle sorte qu'au moins une branche de circuit soit une branche latérale (65) pour permettre un accès externe à au moins un conducteur, à au moins un point (63, 64, 66, 68) entre des extrémités du faisceau de câblage sur sa longueur, en vue d'une mesure électrique ou d'essais.

15. Faisceau de câblage selon la revendication 14, le faisceau étant agencé pour être suffisamment souple pour pouvoir être appliqué sur une surface non plane profilée tridimensionnelle (52), et/ou le faisceau étant formé pour épouser la forme d'une surface non plane profilée tridimensionnelle en vue de son application sur cette surface.
